# FASCICULE DE BREVET EUROPEEN

(11) **EP 1 530 181 B1**
(45) Date de publication et mention de la délivrance du brevet: **31.03.2010**
(21) Numéro de dépôt: 04405621.6
(22) Date de dépôt: 05.10.2004
(51) Int. Cl.: G08B 21/00, H03K 17/95

(54) **Capteur de position de câble**
Kabelpositionssensor
Cable position sensor

(30) Priorité: 06.11.2003 CH 19132003
(43) Date de publication de la demande: 11.05.2005
(73) Titulaire: Optosys SA, 1762 Givisiez (CH)
(72) Inventeur: Rhême, Charles, 1725 Posieux (CH); Heimlicher, Peter, 1700 Fribourg (CH)
(74) Mandataire: AMMANN PATENTANWÄLTE AG BERN

(56) Documents cités:
- US-A- 5 977 662

## Description

La présente invention concerne un capteur de position de câble selon le préambule de la revendication indépendante une et un assemblage de poulie équipé d'au moins un tel capteur.

Il existe de nombreux types d'installations de transport qui utilisent des câbles métalliques pour assurer la traction d'un véhicule, par exemple un téléski ou télésiège, un funiculaire ou toute sorte de téléférique. Un tel câble court sur des poulies qui lui servent de guidage. Un téléférique a en général en plus un ou plusieurs câbles porteurs. Dans ce cas des poulies fixées au véhicule servent de roues sur lesquels il roule le long du câble porteur.

Les poulies pour câbles métalliques présentent une gorge circulaire qui reçoit le câble et définit ainsi en direction radiale et latérale la position normale du câble par rapport à la poulie. Pour la sécurité des installations de transport il est important que le câble garde toujours cette position normale sur les poulies. Si un câble est désaligné par rapport à la gorge et se trouve à gauche ou à droite de celle-ci, cela indique un dysfonctionnement de l'installation qui pourrait, dans le pire des cas, mener au déraillement du câble, c'est à dire à la situation où le câble n'est plus sur la poulie du tout. Pour des raisons de sécurité il est très important de détecter ces situations anormales, qui nécessitent en général un arrêt immédiat de l'installation. Une autre anomalie qui doit être détectée est le blocage d'une poulie, qui a pour conséquence que le câble use la poulie et s'approche graduellement de son axe de rotation.

Un capteur pour la surveillance de la position du câble par rapport à la poulie est décrit dans la demande de brevet internationale WO-99/27649. Ce capteur a plusieurs zones d'influence dans lesquelles il est susceptible de détecter la présence du câble à l'aide de détecteurs de proximité. Un capteur avec trois zones d'influence a trois sorties de signal et le signal à chacune de ces sorties indique pour une zone d'influence particulière si le câble y est détecté ou non. Il se peut, qu'un câble soit détecté dans deux zones d'influence à la fois. Ce capteur comprend pour la surveillance de chaque zone un détecteur de proximité séparé. Il est coûteux et sa durée de vie est limitée vu que le risque d'une défaillance électronique d'un détecteur de proximité est multiplié par le nombre de détecteurs qui sont utilisés dans le capteur. En plus la vérification du bon fonctionnement d'un tel capteur est laborieuse parce qu'une pluralité de détecteurs de proximité doit être testé.

Il est un objectif de la présente invention d'éviter ces inconvénients et de proposer un capteur de position de câble qui permet la surveillance de la position radiale et latérale d'un câble par rapport à une poulie à gorge avec grande sécurité et à un moindre coût. Cet objectif est atteint avec un capteur ayant les caractéristiques de la revendication indépendante 1. D'autres objectifs ressortent des revendications dépendantes qui portent sur des exécutions préférées du capteur et un assemblage de poulie avec un tel capteur.

L'invention est décrite en détail ci-après, en se référant aux dessins qui représentent des exemples d'exécution, à savoir
- figure 1: la coupe transversale d'un câble (selon le plan de coupe A-A dans la figure 8) qui court sur une poulie assortie d'un capteur de position de câble,
- figure 2: les contours du câble et de la poulie de figure 1, ainsi que le capteur de position de câble de la figure 1 en coupe longitudinale partielle,
- figure 3: le signal de détection produit par l'unité de mesure du capteur de la figure 2 en fonction de la distance entre le câble et le capteur,
- figure 4: le schéma fonctionnel du capteur de position de câble de la figure 2,
- figure 5: un schéma électrique simplifié du même capteur pour la distinction de trois zones de proximité,
- figure 6: des signaux, en fonction du temps, dans un circuit selon le schéma de la figure 5 lorsque le câble est éloigné du capteur à une vitesse constante,
- figure 7: un assemblage de poulie avec deux poulies et un câble qui court sur ces poulies et
- figure 8: l'assemblage de poulie de figure 1 vu de dessus.

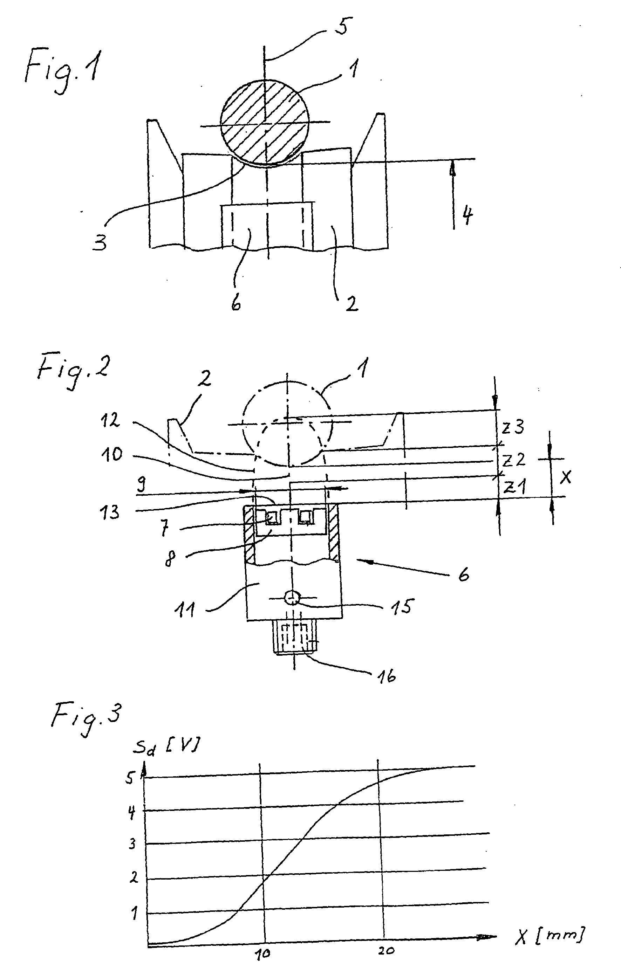

La figure 1 montre une situation typique pour la surveillance de laquelle le capteur de position de câble est conçu: Un câble tracteur ou porteur 1 d'une installation de transport court sur une poulie 2. Plus précisément, le câble est situé dans une gorge 3 de la poulie, qui définit sa position normale par rapport à cette poulie dans le sens radial et latéral, par son radius 4 et son plan de symétrie 5 respectivement.

La gorge 3 de la poulie peut être plus ou moins prononcée et avoir différentes formes. Elle pourrait même avoir une section centrale cylindrique, qui laisserait au câble une certaine liberté de mouvement latérale à l'intérieur de la gorge, mais toujours est-il que le diamètre de la poulie est plus grand à gauche et à droite de la gorge 3 que dans le plan de symétrie 5 de la gorge. Cela signifie qu'un désalignement du câble par rapport à la gorge 3 de la poulie implique aussi un déplacement radial du câble 1 vers l'extérieur. Les deux cas d'exception qui doivent être détectés, le désalignement du câble et le cas d'une poulie bloquée, se manifestent donc par des déplacements radiaux du câble 1 dans des directions opposées, de sorte qu'il serait possible de détecter ces situations par une surveillance de la position du câble 1 dans cette seule direction radiale.

Une surveillance de la position radiale du câble par rapport à la poulie est réalisée avec une unité de mesure inductive qui fonctionne en principe comme l'unité de mesure d'un capteur de proximité inductif ordinaire: Elle émet un champ magnétique alternant et détecte l'atténuation de ce champ magnétique qui résulte si un objet métallique, ici le câble tracteur ou porteur 1, se trouve dans son périmètre.

Vu qu'il s'agit de surveiller la position radiale du câble par rapport à l'axe de la poulie, le capteur est de préférence installé dans le plan de symétrie de la gorge de la poulie, de sorte que son champ magnétique soit dirigé vers le câble. Cela permet de détecter avec une seule unité de mesure inductive des situations où le câble serait trop près ou trop loin du capteur par rapport à la position qu'il a pendant l'opération normale de l'installation de transport.

Lorsque le capteur est installé dans le plan de symétrie de la gorge de la poulie, tout déplacement latéral (c'est à dire parallèle à l'axe de la poulie) du câble implique un accroissement de la distance entre le câble et le capteur. C'est ce qui arrive lors d'un désalignement du câble, qui implique en même temps un déplacement radial du câble vers l'extérieur, comme expliqué plus haut. Pour faire en sorte que ce déplacement vers l'extérieur contribue également à l'accroissement de la distance entre le câble et le capteur, ce capteur est de préférence installé en amont ou en aval de la poulie et du même côté du câble que celle-ci. Les contours d'un capteur de position de câble 6 installé dans cette position sont visibles dans la figure 1.

La figure 2 montre les contours du câble et de la poulie de la figure 1, ainsi que le capteur de position de câble en coupe partielle. L'unité de mesure comporte un oscillateur avec un circuit oscillant avec une bobine 7 qui a un noyau ouvert 8 pour l'émission du champ magnétique dans une direction principale. Ici c'est un noyau de pot, mais ça pourrait aussi être un noyau en E, par exemple. Le capteur est essentiellement sensible dans cette direction et il a, en ce sens, une axe de mesure 10 au centre du champ magnétique, qui indique cette direction principale. De préférence le capteur est installé de sorte que son axe de mesure 10 est situé dans le plan de symétrie 5 de la gorge 3, pour qu'un désalignement du câble soit toujours détecté, peu importe s'il se produit vers la gauche ou vers la droite de la gorge. Le côté d'un désalignement n'a pas d'influence sur le signal de détection si l'axe de mesure 10 est un axe de symétrie du champ magnétique 12. Dans l'exemple c'est le cas: La bobine 7 et le noyau en pot 8 ont des formes cylindriques, de sorte que leur axe commun est un axe de symétrie du champ magnétique 12.

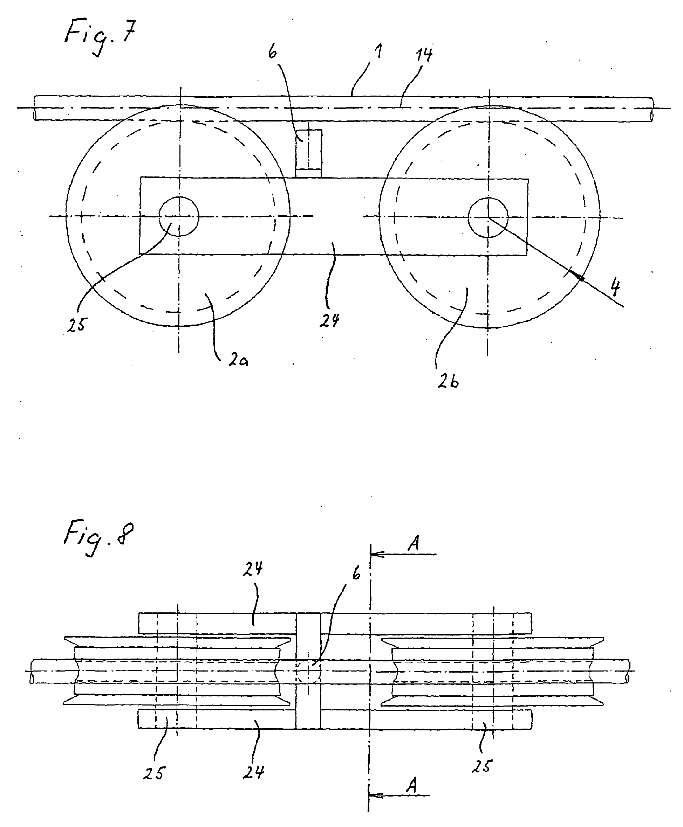

Le capteur 6 a un boîtier 11 et la bobine 7 de l'unité de mesure est agencée à l'intérieur de ce boîtier 11 et émet le champ magnétique 12 à travers l'une de ses parois. Lorsque le câble touche la surface extérieure de cette paroi, dite surface de capteur 13, la distance entre le câble et le capteur est zéro. A moins que ça soit autrement précisé, des distances de mesure ou des longueurs de zones de proximité seront indiquées le long de l'axe de mesure 10 pour un câble 1, représenté par une barre métallique cylindrique d'un diamètre de 30 mm (c'est le diamètre d'un câble moyen), dont la ligne médiane 14 (voir figure 7) coupe l'axe de mesure 10 dans un angle de 90 degrés. La distance maximale à laquelle l'unité de mesure peut détecter la présence d'un câble est la portée de l'unité de mesure.

La détection des différentes situations du câble 1 par rapport à la poulie 2 suppose un capteur 6 avec un champ magnétique 12 d'une portée suffisante. A priori cette portée peut être augmentée par l'augmentation de la largeur de ce champ magnétique. Si c'est une bobine 7 avec un noyau en pot 8, c'est l'augmentation du diamètre extérieur 9 de ce noyau qui permet d'étendre la portée du champ magnétique 12. Toutefois, un large champ magnétique 12 a l'inconvénient que le capteur 6 devient moins sensible à un déplacement latéral du câble 1 par rapport à l'axe de mesure 10, qui est surtout détecté lorsque le câble 1 sort latéralement du champ magnétique 12. De préférence une bobine 7 est utilisée, dont le noyau 8 a une largeur 9 qui correspond au diamètre du câble 1 qu'il s'agit de surveiller, soit en général entre 20 et 40 mm, de sorte que le champ magnétique ait environ cette même largeur. Pour qu'une portée suffisante du capteur puisse néanmoins être atteinte, l'unité de mesure est de préférence agencée de sorte que son champ de mesure 12 soit suffisante pour pouvoir détecter la présence du câble 1 à une distance du noyau 8 de la bobine 7, qui correspond à au moins six dixièmes du diamètre extérieur de ce noyau 8.

Cette grande portée du champ de mesure par rapport à sa largeur implique la nécessité de détecter de faibles variations du champ magnétique, ce qui est surtout difficile à cause de variations de paramètres du circuit oscillant, notamment de la résistance ohmique de la bobine 7 de ce circuit, en fonction de la température. Un circuit oscillant spécifique qui permet de compenser la dépendance en température et d'augmenter ainsi la portée du champ de mesure d'une unité de mesure inductive est décrit dans le brevet EP-70796 du déposant. Une portée de mesure maximale est atteinte lorsque le circuit oscillant est complété d'un circuit de stabilisation thermique comme il est décrit dans le brevet EP-813306 du déposant. Un tel circuit de stabilisation comprend un circuit pour la détermination de la temperature par une mesure de la résistance ohmique de la bobine 7 et un circuit de compensation pour compenser des variations thermiques de paramètres du circuit oscillant, notamment des variations de cette résistance, en fonction de cette température.

Le capteur est agencé de sorte à pouvoir détecter le câble 1 dans au moins trois zones de proximité z1, z2, z3 distinctes à l'intérieur de son champ magnétique 12, qui sont situées à différentes distances du capteur, et à pouvoir produire un signal de sortie du capteur qui contient une information sur la zone de proximité z2 dans laquelle le câble 1 est détecté. De préférence les zones de proximité z1, z2, z3 sont consécutives, c'est à dire il n'y a ni des écarts ni des chevauchements entre différentes zones de proximité. Dans l'exemple c'est le cas: une zone médiane z2, dans laquelle la position du câble peut varier pendant l'opération normale de l'installation de transport, est précédé d'une zone de proximité z1 et suivi d'une zone de proximité z3. Ces dernières sont des zones d'exception, qui permettent la détection de différents types de dysfonctionnement.

Plusieurs zones d'exception z1, z3 pourraient être prévues en deçà et/ou au delà de la zone médiane z2 afin de permettre une détection plus exacte du type et/ou du degré d'un dysfonctionnement. Par exemple deux zones d'exception peuvent être distinguées au delà de la zone médiane afin de permettre la distinction entre un câble désaligné et un câble qui serait déraillé (et donc complètement absent).

Vu que le câble 1 n'est pas un barreau métallique parfait mais un ensemble de fils de fer avec une surface ondulée, la zone médiane z2 a de préférence une longueur d'au moins 8 mm. Afin de garder toujours une distance de sécurité entre la surface de capteur 13 et le câble 1, même au cas où le câble s'approche du capteur suite à un blocage de la poulie 2, la zone médiane commence de préférence à au moins 6 mm de la surface de capteur. Pour qu'un déraillement du câble 1 puisse être détecté avec certitude, la longueur de la zone d'exception z3 au delà de la zone médiane (ou la somme de leurs longueurs s'il y en a plusieurs) est également d'au moins 6 mm. Ainsi le champ magnétique a de préférence une portée d'au moins 20 mm (6 mm + 8 mm + 6 mm).

La détection d'un câble dans la zone médiane z2 est indiqué par le clignotement d'une LED 15. Cela facilite surtout le travail de l'installateur qui, après avoir aligné le câble sur la gorge de la poulie (ou vice versa), doit positionner le capteur par rapport à la poulie de sorte que le câble se trouve dans cette zone médiane.

Le boîtier 11 du capteur est une douille métallique. Du côté de la bobine 7 cette douille est fermée par un matériel non magnétique, en général une résine synthétique, qui n'est pas représentée dans le dessin. De l'autre côté le boîtier 11 a un connecteur électrique pour la connexion de l'alimentation électrique 16 et d'une ligne de signalisation.

Comme déjà mentionné, la bobine 7 fait partie d'une unité de mesure inductive. Plus précisément elle fait partie d'un circuit oscillant de cette unité de mesure, qui produit un champ magnétique alternant émanant de cette bobine 7. Un courant de Foucault est ainsi induit dans l'objet de mesure (le câble), qui atténue le champ magnétique et cette atténuation est détectée par l'unité de mesure et utilisé pour la production d'un signal de détection s_{d}. La figure 3 montre le graphe d'un tel signal s_{d} en fonction de la distance x entre le câble et le capteur. Son niveau croît continuellement avec l'augmentation de la distance et en ce sens on peut dire que le signal de distance est essentiellement proportionnel à la distance entre le capteur et le câble.

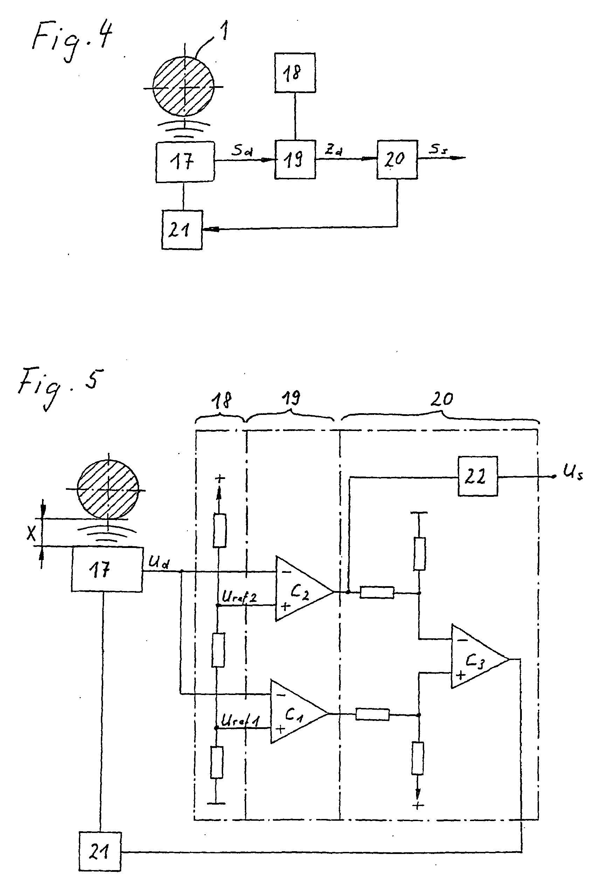

La figure 4 montre le schéma fonctionnel du capteur de position de câble. Il comporte un moyen de référence 18, qui fixe des seuils de référence du signal de détection s_{d} et définit ainsi les zones de proximité. Pour la définition de n zones de proximité consécutives il faut n - 1 seuils de référence. Une unité de comparaison 19 compare le signal de détection s_{d} avec les seuils de référence et une unité de signalisation 20 produit un signal de sortie sₛ, qui contient une information sur la zone dans laquelle le câble est détecté. Cette information identifie en général la zone dans laquelle le câble est détecté. De préférence le signal de sortie sₛ est codé de sorte qu'il puisse être transmis sur une seule ligne de signalisation.

Pour des raisons de sécurité il est important de surveiller non seulement la position du câble mais encore le bon fonctionnement du capteur qui est utilisé pour cette surveillance. Le capteur comporte une unité de contrôle 21, qui est susceptible d'injecter dans un circuit du capteur des impulsions périodiques de contrôle, par exemple des impulsions de tension électrique, qui se répercutent dans le signal de sortie sₛ si le circuit entre le point d'injection et la sortie fonctionne. De préférence les impulsions de contrôle sont injectées au niveau de l'oscillateur de l'unité de mesure inductive 17, de sorte que le signal de sortie contienne une information sur le bon fonctionnement de toute la chaîne de mesure, de comparaison et de signalisation.

L'unité de contrôle a au moins deux modes d'opération qui se distinguent par leurs répercussions dans le signal de sortie, ce qui permet la constatation du mode d'opération de l'unité de contrôle par observation du signal de sortie sₛ. L'unité de signalisation commande le mode d'opération de l'unité de contrôle (ci-après appelé "mode de contrôle") en fonction de la zone z_{d} dans laquelle le câble a été détecté: Le mode de contrôle est utilisé pour le codage du signal de sortie. Cette approche a l'avantage qu'une seule composante périodique du signal de sortie (les répercussions des impulsions de contrôle) contient et l'information de sécurité et tout ou partie de l'information sur la position du câble, ce qui limite la complexité du signal de sortie et facilite son traitement, sa transmission et son interprétation.

Pour des capteurs avec trois ou quatre zones de proximité, l'unité de contrôle préférée a les modes d'opération "activé" et "désactivé", qui sont caractérisés par la présence et l'absence d'impulsions périodiques de contrôle respectivement. Le mode d'opération "activé" doit alors être sélectionné lorsque le câble est détecté dans une zone de travail, c'est à dire une zone de proximité dans laquelle il peut se trouver pendant l'opération normale de l'installation. C'est surtout pendant le travail normal de l'installation, que le fonctionnement du capteur doit être surveillé.

De préférence l'unité de signalisation produit un signal de sortie digital, ayant l'un ou l'autre des états de base 0 ou 1, dans lequel les impulsions de contrôle se répercutent par des impulsions digitales. Le signal de sortie le plus simple résulte alors si l'unité de signalisation commande son état de base et le mode de contrôle pour encoder l'information sur la zone dans laquelle le câble est détecté. Si l'unité de contrôle a les deux modes d'opération "activé" et "désactivé", les combinaisons avec les états de base 0 et 1 du signal de sortie permettent de distinguer quatre zones de proximité.

A priori il serait possible de traiter le signal de détection s_{d} de façon digitale, avec une mémoire dans lequel les seuils de référence seraient enregistrés et un micro-ordinateur pour la comparaison du signal de détection s_{d} avec ces seuils de référence et la production d'un signal de sortie digital. Cette approche aurait l'avantage que le capteur serait programmable, de sorte que la taille des zones de détection ou d'autres paramètres pourraient être facilement adaptées. Toutefois, un micro-ordinateur, et plus généralement tout circuit de logique séquentielle, risque de prendre un état imprévu dans lequel il se bloque. Pour offrir une fiabilité maximale du capteur, un circuit qui ne contient que des composantes analogiques et des éléments de logique combinatoire est préféré. C'est dans ce contexte que le commandement du mode de contrôle en fonction de la zone dans laquelle le câble est détecté s'avère utile.

Le schéma simplifié d'un tel capteur avec trois zones de proximité est représenté dans la figure 5: L'unité de mesure inductive est analogique et le signal de détection s_{d} qu'elle produit est une tension u_{d}. Le moyen de référence est un diviseur de tension qui fixe les tensions de référence u_{ref1} et u_{ref2}. L'unité de comparaison 19 comporte deux comparateurs de tension c1, c2 pour la comparaison de u_{d} avec les tensions de référence u_{ref1} et u_{ref2} respectivement. L'unité de signalisation 20 utilise le signal de sortie du comparateur c2 tel quel comme signal de sortie sₛ du capteur, qui est seulement amplifié par un circuit de sortie 22. On peut dire que le signal de sortie est déduit de la sortie du comparateur c2 par un circuit de logique combinatoire: Même un simple conducteur électrique, qui relierait la sortie de c2 directement avec la fiche du connecteur 16 (voir figure 2) prévue pour le signal de sortie, serait en ce sens un élément de logique combinatoire.

L'unité de contrôle est désactivée lorsque le câble est détecté dans les zones z1 (u_{d} < u_{ref1}) ou z3 (u_{d} > u_{ref2}) et uniquement activée au cas où le câble est détecté dans la zone médiane z2, c'est à dire lorsque u_{ref1} < u_{d} < u_{ref2}. Le comparateur c3 de l'unité de signalisation 20 produit à cette fin un signal digital qui est 1 lorsque le câble est détecté dans les zones z1 ou z3 et qui passe à 0 lorsqu'il est détecté dans la zone de proximité z2. Vu que les signaux aux sorties des comparateurs c1 et c2 sont déjà digitaux, le circuit avec le comparateur c3 qui en déduit un autre signal digital est un circuit de logique combinatoire.

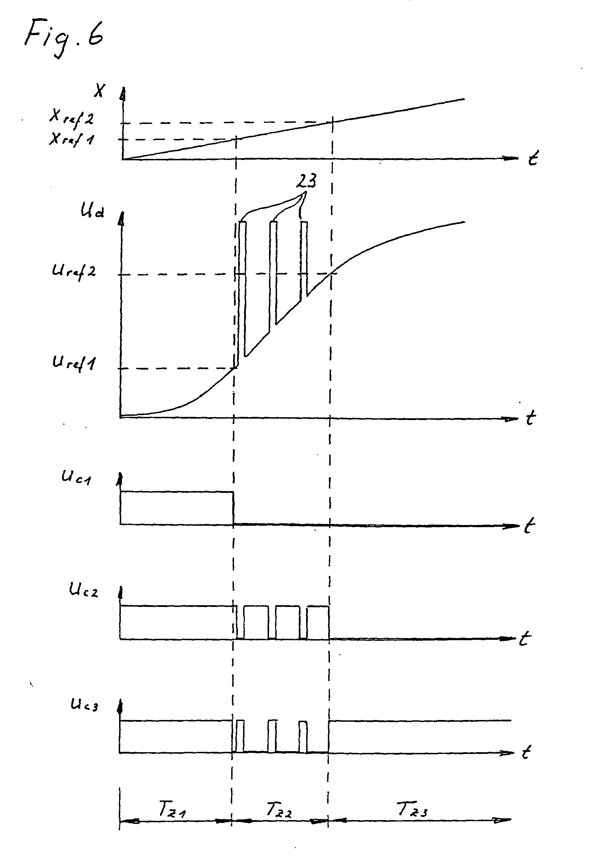

La figure 6 montre en fonction du temps différents signaux dans un circuit selon le schéma de figure 5, lorsque le câble est éloigné du capteur à une vitesse constante. Une exception est le premier graphe, qui ne représente pas un signal électrique mais l'accroissement de la distance x entre le câble 1 et la surface de capteur 13. Le deuxième graphe montre la tension de détection u_{d}, qui monte continuellement comme expliqué plus haut sous référence à la figure 3.

Le moyen de référence fixe les tensions de référence u_{ref1} et u_{ref2} et définit par ce billet des distances de références x_{ref1} et x_{ref2}, qui répartissent le champ de mesure du capteur en trois zones de proximité consécutives. Puisque le câble s'éloigne continuellement, trois périodes de temps T_{z1}, T_{z2} et T_{z3} peuvent être distinguées, dans lesquelles le câble se trouve respectivement dans les zones z1, z2 et z3. Pendant la période T_{z2} l'unité de contrôle est activée et injecte au niveau du circuit oscillant de l'unité de mesure des impulsions de contrôle qui se répercutent par des impulsions de tension périodiques 23 dans la tension de détection u_{d}.

Les trois graphes suivants montrent les tensions u_{c1} u_{c2} et u_{c3} aux sorties des comparateurs c1, c2 et c3. Les impulsions de contrôle se répercutent à la sortie du comparateur c2 comme des impulsions digitales. Ce signal u_{c2} est le signal de sortie du capteur: le niveau de base de ce signal (1 ou 0) et la présence ou l'absence des impulsions de contrôle permet de dire dans quelle zone le câble est détecté. La sortie du comparateur c3 est seulement 0 si le câble est détecté dans le zone z2. Ce signal commande le mode d'opération de l'unité de contrôle. Il contient également la répercussion des impulsions de contrôle, mais ça ne pose aucun problème: vu que c'est l'unité de contrôle qui produit ces impulsions, elle peut facilement être conçue de sorte qu'elle ignore leur écho dans le signal qui commande son mode de contrôle.

Les figures 7 et 8 montrent la construction simplifiée d'un assemblage de poulie d'une installation de transport, qui comporte deux poulies 2a, 2b. Les axes 25 de ces poulies sont reliées par deux éléments latéraux 24, avec lesquels ils forment l'élément de support de l'assemblage. Le capteur de position de câble 6 est fixé sur cet élément de support à proximité de la poulie 2a. Il est clair qu'un tel assemblage pourrait aussi n'avoir qu'une seule poulie ou, au contraire, un plus grand nombre de poulies.

## Revendications

1. Capteur de position de câble (6) pour la surveillance de la position du câble tracteur ou porteur (1) d'une installation de transport sur une poulie à gorge (2), avec une unité de mesure de distance inductive (17) avec un circuit oscillant avec une bobine (7) pour émettre un champ magnétique alternant (12) afin d'induire un courant de Foucault dans le câble et susceptible de détecter une atténuation du champ magnétique due au courant de Foucault,
**caractérisé en ce que**
il comporte en outre des moyens (19) pour comparer l'atténuation à des seuils de référence définissant des plages d'atténuation correspondant à au moins trois zones de proximité (z1, z2, z3) distinctes à l'intérieur du champ magnétique (12), situées à différentes distances du capteur (6), et qu'il est susceptible de produire un signal de sortie contenant une information sur la zone de proximité dans laquelle le câble (1) est détecté.

2. Capteur selon la revendication 1, **caractérisé en ce que** les zones de proximité (z1, z2, z3) dans lesquelles la présence du câble peut être détectée sont consécutives.

3. Capteur selon l'une des revendications 1 ou 2, **caractérisé en ce que** les zones de proximité (z1, z2, z3) comprennent une zone médiane (z2) qui atteint une longueur d'au moins 8 mm, ainsi qu'au moins une zone de proximité (z1) en deçà et une zone de proximité (z3) au delà de cette zone médiane.

4. Capteur selon l'une des revendications 1 à 3, **caractérisé en ce que** la bobine (7) a un noyau ouvert (8) pour l'émission du champ magnétique alternant (12) dans une direction principale (10) et l'unité de mesure est agencée de sorte que la portée de son champ de mesure dans cette direction principale soit suffisante pour pouvoir détecter la présence du câble (1) à une distance de ce noyau (8) qui correspond à au moins six dixièmes de son diamètre extérieur (9).

5. Capteur selon la revendication 4, **caractérisé en ce que** le circuit oscillant est complété par un circuit de stabilisation thermique qui comprend un circuit pour la détermination de la température par une mesure de la résistance ohmique de la bobine (7) et un circuit de compensation pour compenser des variations thermiques de paramètres du circuit oscillant, notamment de tels variations de cette résistance, en fonction de cette temperature.

6. Capteur selon l'une des revendications 4 ou 5,
**caractérisé en ce que** le noyau (8) est d'une largeur de 20 à 40 mm, pour que le champ magnétique (12) ait environ cette même largeur.

7. Capteur selon l'une des revendications 1 à 6,
**caractérisé en ce que** son champ de mesure a un axe de symétrie (10) et qu'il est susceptible d'être installé de sorte que cet axe de symétrie (10) est situé dans le plan de symétrie (5) de la gorge (3) de la poulie et de préférence de sorte qu'il se trouve du même côté du câble (1) comme la poulie (2).

8. Capteur selon l'une quelconque des revendications précédentes, **caractérisé en ce que** le signal de sortie (sₛ) est codé de sorte qu'il peut être transmis sur une seule ligne de signalisation.

9. Capteur selon l'une quelconque des revendications précédentes, **caractérisé en ce que** l'unité de mesure (17) est agencée de sorte à pouvoir produire un signal de détection analogique (s_{d}) essentiellement proportionnel à la distance (x) entre le câble (1) et le capteur (6) et que le capteur comporte un moyen de référence (18) par lequel au moins deux seuils de référence du signal de détection sont fixés, définissant au moins trois zones de proximité (z1, z2, z3), une unité de comparaison (19) pour la comparaison du signal de détection (s_{d}) avec les seuils de référence et une unité de signalisation (20) pour la production du signal de sortie (sₛ) en fonction du résultat de cette comparaison.

10. Capteur selon la revendication 9, **caractérisé en ce qu'**il comporte une unité de contrôle (21) qui est susceptible d'injecter dans un circuit du capteur des impulsions périodiques de contrôle qui se répercutent dans le signal de sortie donnant une information sur le bon fonctionnement du circuit entre le point d'injection et la sortie, que cette unité a au moins deux modes d'opération qui se distinguent par leurs répercussions dans le signal de sortie (sₛ) et que le mode d'opération est commandé par l'unité de signalisation (20) en fonction de la zone de proximité (z1, z2, z3) dans laquelle le câble est détecté.

11. Capteur selon la revendication 9, **caractérisé en ce que** l'unité de mesure (17) comporte un oscillateur avec un circuit oscillant avec une bobine (7) pour la production du champ magnétique alternant (12) et que l'unité de contrôle (21) injecte les impulsions de contrôle dans cet oscillateur, de sorte que leur répercussion dans le signal de sortie (sₛ) donne une information sur le bon fonctionnement de toute la chaîne de mesure, de comparaison et de signalisation.

12. Capteur selon la revendication 10 ou 11, **caractérisé en ce que** l'unité de contrôle (21) a un mode d'opération activé et un mode d'opération désactivé qui sont
**caractérisés par** la présence et l'absence d'impulsions périodiques de contrôle respectivement.

13. Capteur selon l'une des revendications 10 à 12,
**caractérisé en ce que** le signal de sortie (sₛ) est digital, ayant l'un ou l'autre des états de base 0 ou 1, que les impulsions de contrôle se répercutent dans ce signal de sortie par des impulsions digitales et que l'unité de signalisation (20) est agencée de sorte à pouvoir commander et l'état de base du signal de sortie et le mode de contrôle en fonction de la zone de proximité dans laquelle le câble est détecté.

14. Capteur selon la revendication 13, **caractérisé en ce que** le signal de détection (s_{d}) est une tension de détection (u_{d}), que les impulsions de contrôle se répercutent dans ce signal de détection (s_{d}) par des impulsions de tension (23), que les seuils de référence sont fixés comme des tensions de référence (u_{ref1}, u_{ref2}) et l'unité de comparaison (19) comporte pour chaque seuil de référence un comparateur (c1, c2) pour leur comparaison avec la tension de détection (u_{d}), et que l'unité de signalisation (20) comporte un circuit de logique combinatoire connecté à la sortie d'au moins un de ces comparateurs (c1, c2) pour la production du signal de sortie (sₛ) du capteur.

15. Capteur selon la revendication 14, **caractérisé en ce que** l'unité de signalisation (20) comporte un circuit de logique combinatoire connecté à la sortie d'au moins un des comparateurs (c1, c2) pour la production d'un signal qui détermine le mode de contrôle.

16. Capteur selon l'une quelconque des revendications précédentes, **caractérisé en ce que** le moyen de référence (18) définit au plus quatre zones de proximité (z1, z2, z3) et de préférence exactement trois zones de proximité.

17. Assemblage de poulie pour une installation de transport avec un câble porteur ou tracteur, comprenant un élément de support avec au moins une poulie à gorge (2a, 2b) rotative et au moins un capteur de position de câble (6) selon l'une quelconque des revendications précédentes, fixé à l'élément de support à proximité d'une poulie (2a).

## Claims

1. Rope position sensor (6) for the surveillance of the position of the traction or carrying rope (1) of a transport installation on a grooved pulley (2), comprising an inductive distance measuring unit (17) with an oscillating circuit with a coil (7) for emitting an alternating magnetic field (12) in order to induce an eddy current in the rope, and adapted to detect an attenuation of the magnetic field due to the eddy current, **characterised in that**
it further comprises means (19) for comparing the attenuation to reference thresholds defining attenuation ranges corresponding to at least three distinct proximity zones (z1, z2, z3) within the magnetic field (12) that are situated at different distances from the sensor (6), and **in that** it is adapted to produce an output signal containing an information on the proximity zone in which the rope (1) is being detected.

2. Sensor according to claim 1, **characterised in that** the proximity zones (z1, z2, z3) in which the presence of the rope is detectable are consecutive.

3. Sensor according to one of claims 1 or 2, **characterised in that** the proximity zones (z1 z2, z3) comprise an intermediate zone (z2) attaining a length of at least 8 mm, as well as at least one proximity zone (z1) on the nearer side and one proximity zone (z3) on the farther side of that intermediate zone.

4. Sensor according to one of claims 1 to 3, **characterised in that** the coil (7) has an open core (8) for emitting the alternating magnetic field (12) in a main direction (10) and the measuring unit is arranged such that the range of its measuring field in this main direction is sufficient for detecting the presence of the rope (1) at a distance from the core (8) that corresponds to at least six tenths of its external diameter (9).

5. Sensor according to claim 4, **characterised in that** the oscillating circuit is complemented by a thermal stabilizing circuit comprising a circuit for determining the temperature by a measure of the ohmic resistance of the coil (7) and a compensating circuit for compensating thermal variations of parameters of the oscillating circuit, especially of variations of that resistance, in function of that temperature.

6. Sensor according to one of claims 4 or 5, **characterised in that** the core (8) has a width of 20 to 40 mm so that the magnetic field (12) has approximately that same width.

7. Sensor according to one of claims 1 to 6, **characterised in that** its measuring field has an axis of symmetry (10), and that it is adapted to be mounted such that this axis of symmetry (10) is situated in the plane of symmetry (5) of the groove (3) of the pulley and preferably such that it is located on the same side of the rope (1) as the pulley (2).

8. Sensor according to any one of the preceding claims, **characterised in that** the output signal (sₛ) is encoded so as to allow its transmission on a single signalling line.

9. Sensor according to any one of the preceding claims, **characterised in that** the measuring unit (17) is adapted to produce an analogue detection signal (s_{d}) that is essentially proportional to the distance (x) between the rope (1) and the sensor (6), and **in that** the sensor comprises a reference means (18) by which at least two reference thresholds of the detection signal are determined, thereby defining at least three proximity zones (z1, z2, z3), a comparator unit (19) for comparing the detection signal (s_{d}) to the reference thresholds, and a signalling unit (20) for generating the output signal (sₛ) as a function of the result of the comparison.

10. Sensor according to claim 9, **characterised in that** it comprises a monitoring unit (21) adapted to inject periodic monitoring pulses into a circuit of the sensor which repercuss in the output signal and provide an information on the proper operation of the circuit between the injection point and the output, **in that** this unit has at least two operation modes distinguishing themselves by their impact upon the output signal (sₛ), and **in that** the operation mode is controlled by the signalling unit (20) as a function of the proximity zone (z1, z2, z3) in which the rope is being detected.

11. Sensor according to claim 9, **characterised in that** the measuring unit (17) comprises an oscillator including an oscillating circuit with a coil (7) for producing the alternating magnetic field (12), and **in that** the monitoring unit (21) injects the monitoring pulses into this oscillator such that their repercussion in the output signal (sₛ) provides an information on the proper operation of the entire measuring, comparison, and signalling chain.

12. Sensor according to claim 10 or 11, **characterised in that** the monitoring unit (21) has an activated and a deactivated mode of operation which are **characterised by** the presence and the absence of periodic monitoring pulses, respectively.

13. Sensor according to one of claims 10 to 12, **characterised in that** the output signal (sₛ) is a digital signal having either one of the basic states 0 or 1, **in that** the monitoring pulses impact this output signal as digital pulses, and **in that** the signalling unit (20) is adapted to control both the basic state of the output signal and the monitoring mode as a function of the proximity zone in which the rope is being detected.

14. Sensor according to claim 13, **characterised in that** the detection signal (s_{d}) is a detection voltage (u_{d}), **in that** the monitoring pulses impact this detection signal (s_{d}) as voltage pulses (23), **in that** the reference thresholds are determined as reference voltages (u_{ref1}, u_{ref2}) and the comparator unit (19) comprises a comparator (c1, c2) for each reference threshold to compare them to the detection voltage (u_{d}), and **in that** the signalling unit (20) comprises a combinatorial logic circuit connected to the output of at least one of these comparators (c1, c2) for generating the output signal (sₛ) of the sensor.

15. Sensor according to claim 14, **characterised in that** the signalling unit (20) comprises a combinatorial logic circuit connected to the output of at least one of the comparators (c1, c2) for producing a signal that determines the monitoring mode.

16. Sensor according to any one of the preceding claims, **characterised in that** the reference means (18) defines four proximity zones (z1, z2, z3) at the most, and preferably exactly three proximity zones.

17. Pulley assembly for a transport installation having a carrying or traction rope, comprising a carrier element with at least one rotating grooved pulley (2a, 2b) and with at least one rope position sensor (6) according to any one of the preceding claims that is fastened to the carrier element near one of the pulleys (2a).

## Patentansprüche

1. Seilpositionssensor (6) zur Überwachung der Position des Zug- oder Tragseils (1) einer Transportanlage auf einer Rillenscheibe (2), mit einer induktiven Abstandsmesseinheit (17) mit einem Schwingkreis mit einer Spule (7) zum Aussenden eines magnetischen Wechselfelds (12), um im Seil einen Wirbelstrom zu induzieren, und geeignet dafür, eine Abschwächung des Magnetfelds infolge des Wirbelstroms zu erfassen, **dadurch gekennzeichnet, dass**
er zudem Mittel (19) zum Vergleichen der Abschwächung mit Referenzschwellenwerten aufweist, welche Abschwächungsbereiche definieren, die mindestens drei verschiedenen Näherungsbereichen (z1, z2, z3) innerhalb des Magnetfelds (12) in verschiedenen Abständen vom Sensor (6) entsprechen, und in der Lage ist, ein Ausgangssignal zu erzeugen, das eine Information über die Näherungszone enthält, in der das Seil (1) erfasst wird.

2. Sensor nach Anspruch 1, **dadurch gekennzeichnet, dass** die Näherungsbereiche (z1, z2, z3), in welchen die Anwesenheit des Seils erfassbar ist, aufeinander folgen.

3. Sensor nach einem der Ansprüche 1 oder 2, **dadurch gekennzeichnet, dass** die Näherungsbereiche (z1, z2, z3) einen Mittelbereich (z2) mit einer Länge von mindestens 8 mm sowie mindestens einen Näherungsbereich (z1) diesseits und einen Näherungsbereich (z3) jenseits dieses Mittelbereichs umfassen.

4. Sensor nach einem der Ansprüche 1 bis 3, **dadurch gekennzeichnet, dass** die Spule (7) einen offenen Kern (8) zum Aussenden des magnetischen Wechselfelds (12) in eine Hauptrichtung (10) aufweist und die Messeinheit derart ausgebildet ist, dass die Reichweite ihres Messfelds in dieser Hauptrichtung genügend ist, um die Anwesenheit des Seils (1) in einem Abstand vom Kern (8) erfassen zu können, der mindestens sechs Zehnteln seines Aussendurchmessers (9) entspricht.

5. Sensor nach Anspruch 4, **dadurch gekennzeichnet, dass** der Schwingkreis zusätzlich eine Wärmestabilisierungsschaltung aufweist, die eine Schaltung zur Temperaturbestimmung durch eine Messung des ohmschen Widerstands der Spule (7) und eine Kompensationsschaltung zur Kompensation der thermischen Schwankungen von Parametern des Schwingkreises in Abhängigkeit von dieser Temperatur umfasst, insbesondere von Schwankungen des besagten Widerstands.

6. Sensor nach einem der Ansprüche 4 oder 5, **dadurch gekennzeichnet, dass** der Kern (8) eine Breite von 20 bis 40 mm aufweist, damit das Magnetfeld (12) ungefähr dieselbe Breite aufweist.

7. Sensor nach einem der Ansprüche 1 bis 6, **dadurch gekennzeichnet, dass** sein Messfeld eine Symmetrieachse (10) aufweist, und dass er geeignet ist für einen Einbau derart, dass diese Symmetrieachse (10) in der Symmetrieebene (5) der Rille (3) der Scheibe liegt und vorzugsweise derart, dass er sich auf der gleichen Seite des Seils (1) wie die Scheibe (2) befindet.

8. Sensor nach einem der vorstehenden Ansprüche, **dadurch gekennzeichnet, dass** das Ausgangssignal (sₛ) derart codiert ist, dass es auf einer einzigen Signalleitung übertragbar ist.

9. Sensor nach einem der vorstehenden Ansprüche, **dadurch gekennzeichnet, dass** die Messeinheit (17) dazu ausgebildet ist, ein analoges Erfassungssignal (s_{d}) zu erzeugen, das im Wesentlichen proportional zum Abstand (x) zwischen dem Seil (1) und dem Sensor (6) ist, und dass der Sensor ein Referenzmittel (18) aufweist, durch das mindestens zwei Referenzschwellenwerte des Erfassungssignals festgelegt sind, die mindestens drei Näherungsbereiche (z1, z2, z3) definieren, sowie eine Vergleichseinheit (19) zum Vergleich des Erfassungssignals (s_{d}) mit den Referenzschwellenwerten und eine Signaleinheit (20) zur Erzeugung des Ausgangssignals (sₛ) in Abhängigkeit vom Resultat des Vergleichs.

10. Sensor nach Anspruch 9, **dadurch gekennzeichnet, dass** er eine Kontrolleinheit (21) aufweist, die es gestattet, periodische Kontrollimpulse in eine Schaltung des Sensors einzuspeisen, die sich auf das Ausgangssignal auswirken und eine Information über das richtige Funktionieren der Schaltung zwischen dem Einspeisepunkt und dem Ausgang liefern, dass diese Einheit mindestens zwei Betriebsarten aufweist, die sich durch ihre Auswirkungen auf das Ausgangssignal (sₛ) unterscheiden, und dass die Betriebsart von der Signaleinheit (20) in Abhängigkeit vom Näherungsbereich (z1, z2, z3) bestimmt wird, in dem das Seil erfasst wird.

11. Sensor nach Anspruch 9, **dadurch gekennzeichnet, dass** die Messeinheit (17) einen Oszillator mit einem Schwingkreis mit einer Spule (7) zur Erzeugung des magnetischen Wechselfelds (12) aufweist, und dass die Kontrolleinheit (21) Kontrollimpulse in diesen Oszillator einspeist, so dass ihre Auswirkung auf das Ausgangssignal (sₛ) eine Information über das richtige Funktionieren der gesamten Mess-, Vergleichs- und Signalkette liefert.

12. Sensor nach Anspruch 10 oder 11, **dadurch gekennzeichnet, dass** die Kontrolleinheit (21) eine aktivierte Betriebsart und eine deaktivierte Betriebsart aufweist, die durch die Anwesenheit bzw. die Abwesenheit von periodischen Kontrollimpulsen **gekennzeichnet** sind.

13. Sensor nach einem der Ansprüche 10 bis 12, **dadurch gekennzeichnet, dass** das Ausgangssignal (sₛ) digital ist mit einem der Grundzustände 0 oder 1, dass sich die Kontrollimpulse in diesem Ausgangssignal als digitale Impulse auswirken, und dass die Signaleinheit (20) dazu ausgebildet ist, sowohl den Grundzustand des Ausgangssignals als auch den Kontrollmodus in Funktion des Näherungsbereichs zu steuern, in dem das Seil erfasst wird.

14. Sensor nach Anspruch 13, **dadurch gekennzeichnet, dass** das Erfassungssignal (s_{d}) eine Erfassungsspannung (u_{d}) ist, dass sich die Kontrollimpulse in diesem Erfassungssignal (s_{d}) als Spannungsimpulse (23) auswirken, dass die Referenzschwellenwerte als Referenzspannungen (u_{ref1}, u_{ref2}) festgelegt sind und die Vergleichseinheit (19) für jeden Referenzschwellenwert einen Komparator (c1, c2) für deren Vergleich mit der Erfassungsspannung (u_{d}) aufweist, und dass die Signaleinheit (20) eine am Ausgang mindestens eines dieser Komparatoren (c1, c2) angeschlossene kombinatorische Logikschaltung für die Erzeugung des Ausgangssignals (sₛ) des Sensors aufweist.

15. Sensor nach Anspruch 14, **dadurch gekennzeichnet, dass** die Signaleinheit (20) eine an den Ausgang mindestens eines der Komparatoren (c1, c2) angeschlossene kombinatorische Logikschaltung für die Erzeugung eines Signals aufweist, das den Kontrollmodus bestimmt.

16. Sensor nach einem der vorstehenden Ansprüche, **dadurch gekennzeichnet, dass** das Referenzmittel (18) höchstens vier Näherungsbereiche (z1, z2, z3) und vorzugsweise genau drei Näherungsbereiche definiert.

17. Scheibenzusammenbau für eine Transportanlage mit einem Trag- oder Zugseil, mit einem Träger mit mindestens einer drehenden Rillenscheibe (2a, 2b) und mindestens einem Seilpositionssensor (6) gemäss einem der vorstehenden Ansprüche, der in der Nähe einer Scheibe (2a) am Träger befestigt ist.
